# EUROPEAN PATENT APPLICATION

(11) **EP 2 525 421 A2**
(43) Date of publication of application: **21.11.2012**
(21) Application number: 12166545.9
(22) Date of filing: 03.05.2012
(51) Int. Cl.: H01L 35/30

(54) **Thermoelectric conversion module**

(30) Priority: 17.05.2011 JP 2011110883
(71) Applicant: Kabushiki Kaisha Toyota Jidoshokki, Kariya-shi, Aichi 448-8671 (JP)
(72) Inventor: Okuda, Motoaki, Kariya-shi, Aichi 448-8671 (JP); Yokomachi, Naoya, Kariya-shi, Aichi 448-8671 (JP); Akiyama, Hirokuni, Kariya-shi, Aichi 448-8671 (JP); Morisaku, Naoto, Kariya-shi, Aichi 448-8671 (JP)
(74) Representative: TBK

(57) **Abstract**

A thermoelectric conversion module includes a plurality of first substrates and a plurality of second substrates disposed to face each other, a plurality of first electrodes and a plurality of second electrodes, a plurality of thermoelectric conversion elements, a base plate, first fins and second fins. Each inner surface of the first substrate faces the respective inner surface of the second substrate. The first electrode is joined to the respective inner surface of the first substrate and the second electrode the respective inner surface of the second substrate. The thermoelectric conversion elements are electrically connected to each other through the first and the second electrodes. The base plate is thermally joined to the outer surfaces of the first substrates. Each first fin is thermally joined to the outer surface of the base plate. Each second fin is thermally and directly joined to the respective outer surface of the second substrate.

## Description

### BACKGROUND OF THE INVENTION

The present invention relates to a thermoelectric conversion module.

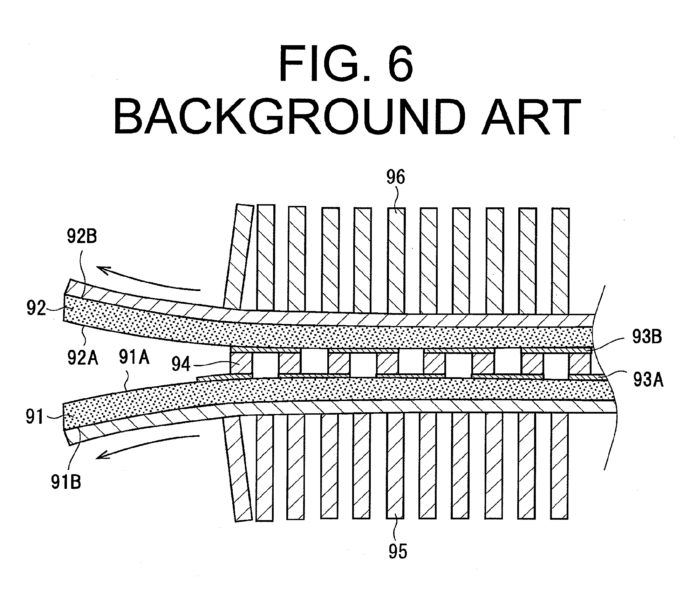

Japanese Patent Application Publication No. 2002-111079 discloses a conventional thermoelectric conversion module. As shown in Fig. 6, the thermoelectric conversion module includes a first substrate 91 and a second substrate 92 having inner surfaces 91A, 92A facing each other and outer surfaces 91B, 92B, respectively. The thermoelectric conversion module further includes a plurality of the electrodes 93A, 93B disposed on the inner surfaces 91A, 92A of the first and the second substrates 91, 92 and a plurality of the thermoelectric conversion elements 94 electrically connected in series through the electrodes 93A, 93B.

According to the thermoelectric conversion element 94 of the thermoelectric conversion module which operates on the Peltier effect, heat absorption occurs on the first substrate 91 side of the thermoelectric conversion module 94 and heat radiation occurs on the opposite second substrate 92 side of the thermoelectric conversion module 94, and vice versa. Such conventional thermoelectric conversion module is being employed in air conditioners as a device for cooling and heating a heat exchange medium between parts such as the first and the second substrates 91, 92. The thermoelectric conversion module is also capable of generating electric power from temperature differences based on Seebeck effect.

As disclosed in the Japanese Patent Application Publication No. 2007-173301, the thermoelectric conversion module may have first and the second fins 95, 96 disposed on the outer surfaces 91B, 92B of the first and the second substrates 91, 92, respectively, for enhancing the effects of heat absorption and radiation or heat receiving. According to the above Publication, the first and the second fins 95, 96 are made of aluminum as a heat-transfer material and directly connected to the outer surfaces 91B, 92B of the first and the second substrates 91, 92 by brazing.

According to the inventors of the above Publication, direct connection of the first and the second fins 95, 96 to the first and the second substrates 91, 92 enhances the effects of heat absorption and radiation or heat receiving. According to the results of CAE (computer aided engineering) analysis, however, the first and the second substrates 91, 92 and the first and the second fins 95, 96 are exposed to high temperature when brazing the first and the second fins 95, 96 to the first and the second substrates 91, 92. When the temperature of the first and the second substrates 91, 92 and the first and the second fins 95, 96 is resumed to a normal level, the first and the second substrates 91, 92 are thermally deformed, as indicated by arrows in Fig. 6. Thus, the thermoelectric conversion elements 94 tend to be damaged by application of the stress due to the deformation.

The first and the second substrates 91, 92 and the first and the second fins 95, 96 may be made smaller in size to reduce the stress. When the first and the second substrates 91, 92 are made smaller, however, the number of the thermoelectric conversion elements 94 which may be installed on the inner surfaces 91A, 92A need to be reduced, with the result that the performance of the thermoelectric conversion module is decreased. Meanwhile, when the first and the second fins 95, 96 are made smaller, the effects of heat absorption and radiation or heat receiving are reduced, with the result that the performance of the thermoelectric conversion module is decreased.

It may be contemplated that plural thermoelectric conversion modules are combined together so as to compensate for the decrease in the performance of each thermoelectric conversion module. However, when the number of the thermoelectric conversion modules is increased, it becomes difficult to arrange and handle the wirings connected to the respective thermoelectric conversion modules, which invites a problem that a mounting space for the thermoelectric conversion modules in an air conditioner or power generating equipment is reduced. This problem becomes noticeable particularly when an air conditioner or power generating equipment is mounted in a vehicle having a limited mounting space.

The present invention is directed to providing a thermoelectric conversion module offering high performance and ease of mounting.

### SUMMARY OF THE INVENTION

In accordance with the present invention, a thermoelectric conversion module includes a plurality of first substrates and a plurality of second substrates disposed to face each other, a plurality of first electrodes, a plurality of a second electrodes, a plurality of thermoelectric conversion elements, a base plate, first fins and second fins. The first substrate including an inner surface and an outer surface and the second substrate including an inner surface and an outer surface are disposed to face each other. Each inner surface of the first substrate faces the respective inner surface of the second substrate. The first electrode is joined to the inner surface of the respective first substrate, and the second electrode is joined to the respective inner surface of the second substrate. The thermoelectric conversion elements are electrically connected to each other through the first and the second electrodes. The base plate including an outer surface is made of a heat-transfer material and thermally joined to the outer surfaces of the first substrates. Each first fin is made of a heat-transfer material and thermally joined to the outer surface of the base plate. Each second fin is made of a heat-transfer material and thermally and directly joined to the respective outer surface of the second substrate.

Other aspects and advantages of the invention will become apparent from the following description, taken in conjunction with the accompanying drawings, illustrating by way of example the principles of the invention.

### BRIEF DESCRIPTION OF THE DRAWINGS

The invention together with objects and advantages thereof, may best be understood by reference to the following description of the presently preferred embodiments together with the accompanying drawings in which:
Fig. 1 is a schematic configuration diagram of a vehicle air conditioner according to a first preferred embodiment of the present invention;
Fig. 2 is a perspective view showing a thermoelectric conversion module of the vehicle air conditioner of Fig. 1;
Fig. 3 is an exploded perspective view showing the thermoelectric conversion module of Fig. 2;
Fig. 4 is a cross-sectional fragmentary view taken along the line V-V' in FIG. 2;
Fig. 5 is a cross-sectional view taken along the line VI-VI' in FIG. 2; and
Fig. 6 is a cross-sectional fragmentary view of a conventional thermoelectric conversion module, showing the CAE analysis results of the module.

### DETAILED DESCRIPTION OF THE PREFERRED EMBODIMENT

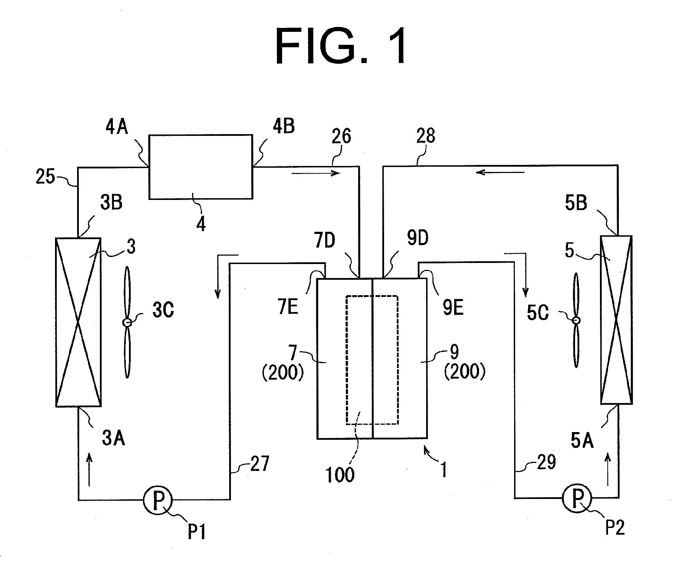

The following will describe a preferred embodiment of a thermoelectric conversion module applied to a vehicle air conditioner with reference to Figs. 1 through 5.

Referring to Fig. 1, the vehicle air conditioner includes a thermoelectric conversion module 1, a radiator 3, and a vehicle interior heat exchanger 5. Numeral 4 designates a vehicle engine.

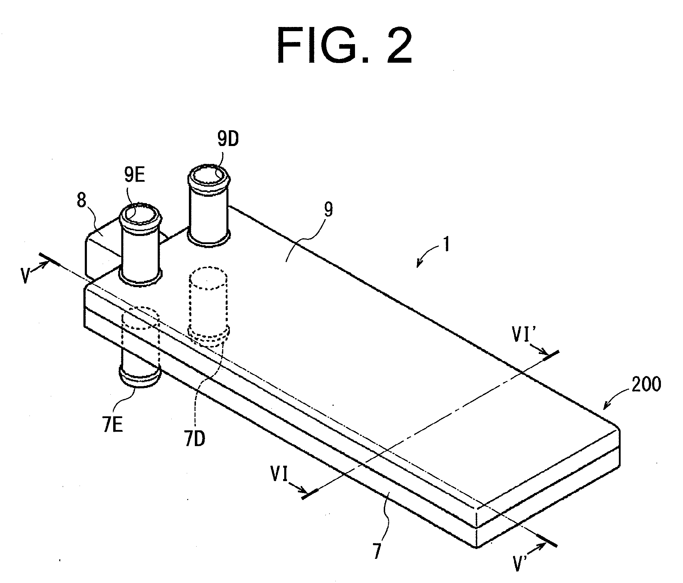

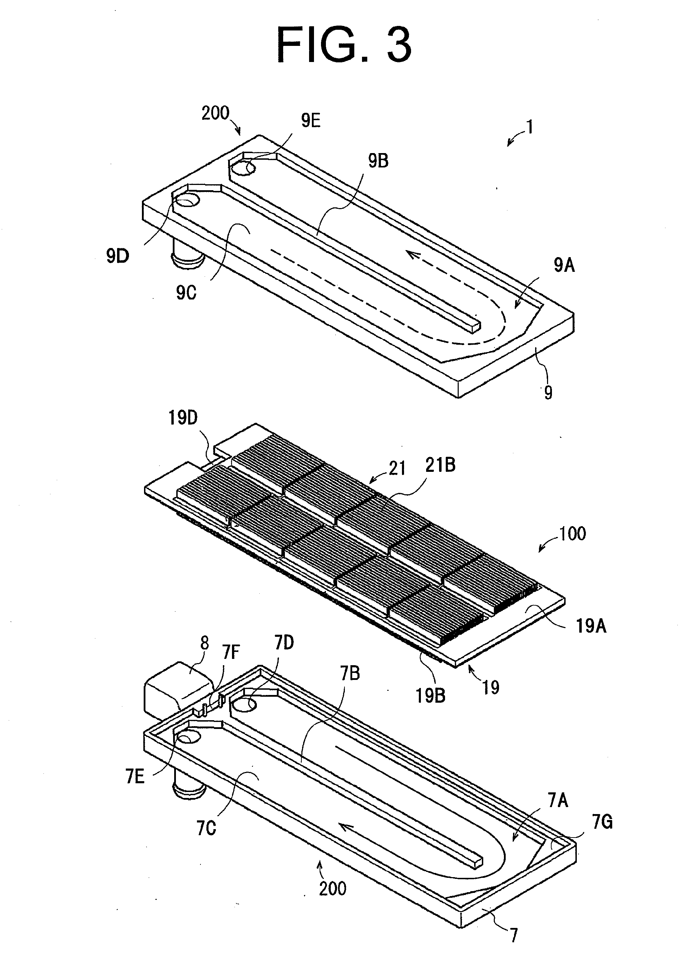

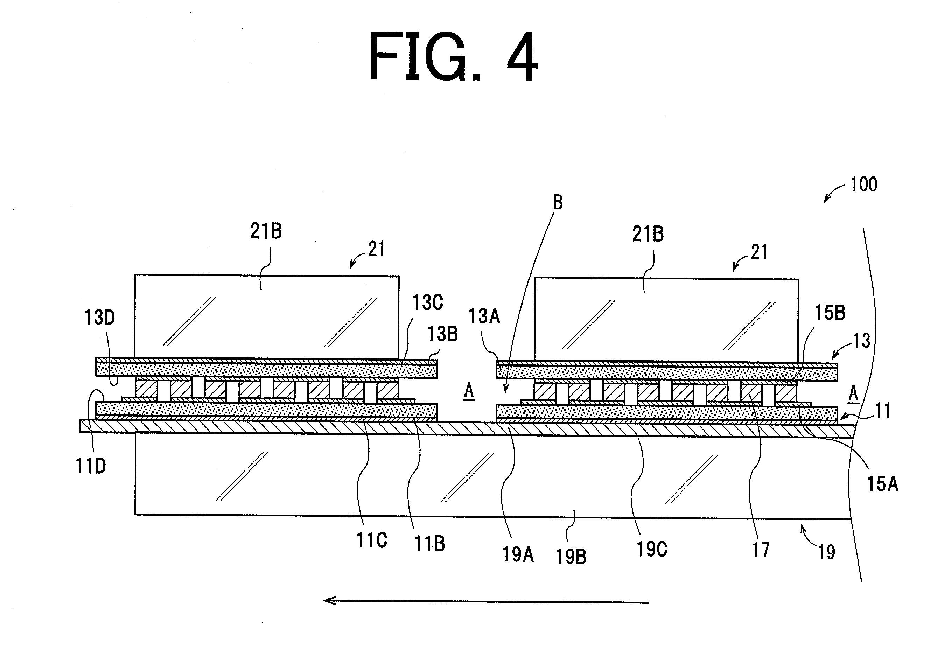

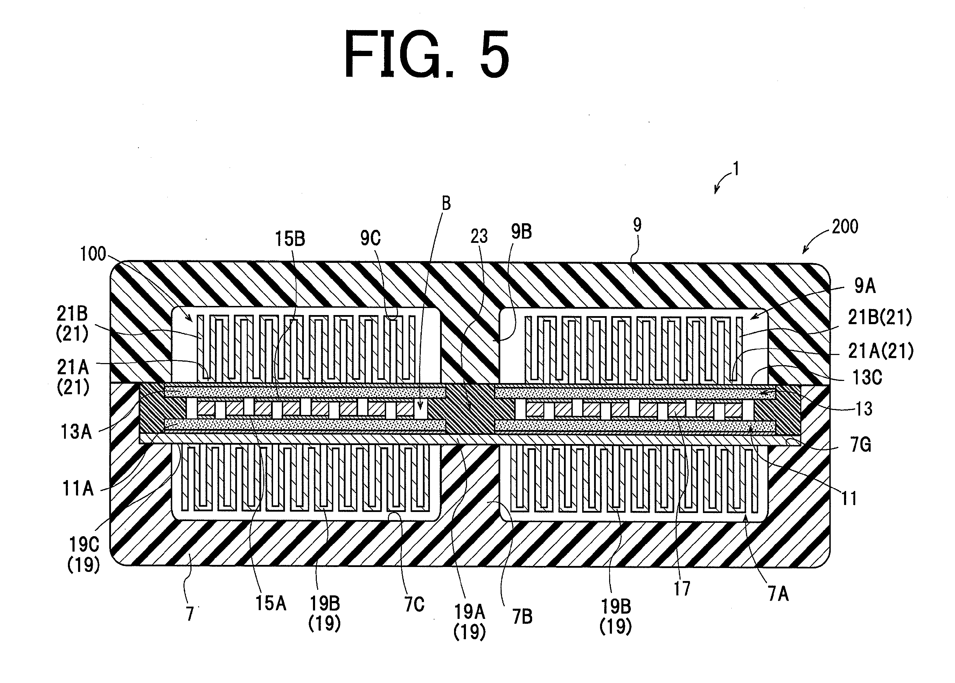

The thermoelectric conversion module 1 has an appearance shown in Fig. 2. Referring to Fig. 3, the thermoelectric conversion module 1 includes a module proper 100 and a case 200. The case 200 includes a first housing 7 and a second housing 9. The module proper 100 is accommodated between the first and the second housings 7 and 9. For ease of understanding, the second housing 9 is shown upside down in Fig. 3, and the first and the second housings 7, 9 are omitted in Fig. 4. The module proper 100 and the first and the second housings 7, 9 are shown simplified in Figs. 4 and 5.

Referring to Fig. 4, the module proper 100 includes a plurality of pairs of first and second substrates 11, 13, a plurality of first electrodes 15A, and a plurality of second electrodes 15B, a plurality of thermoelectric conversion elements 17 and first and second fins 19, 21. The first and the second electrodes 15A and 15B are disposed on the first and the second substrates 11, 13, respectively. Each thermoelectric conversion element 17 is disposed between the first substrate 11 and the second substrate 13.

The first and the second substrates 11, 13 are formed in the same regular square shape. The second substrate 13 is made small for reducing the stress in the thermoelectric conversion elements 17 produced when the second substrate 13 is thermally deformed. The first and the second substrates 11, 13 include ceramic plates 11A, 13A made of aluminum nitride and formed in the same regular square shape and aluminum foils 11C, 13C joined to outer surfaces 11B, 13B of the ceramic plates 11A, 13A, respectively. The aluminum foils 11C, 13C are joined to the ceramic plates 11A, 13A by brazing, respectively. The outer surface of the first substrate 11 corresponds to the outer surface of the aluminum foil 11C, and the outer surface of the second substrate 13 corresponds to the outer surface of the aluminum foil 13C. The aluminum foils 11C, 13C serves as the metal foil of the present invention. The first and the second substrates 11, 13 are insulated sufficiently by the ceramic plates 11A, 13A, respectively, and the first and the second substrates 11, 13 are easily joined to the first fin 19 or the second fin 21 by the aluminum foils 11C, 13C, respectively. The ceramic plates 11A, 13A may be made of a material such as aluminum nitride, and the aluminum foils 11C, 13C may be made of a material such as aluminum or copper.

The first substrate 11 and the second substrate 13 are disposed to face each other. The first and the second electrodes 15A, 15B are joined to the facing inner surfaces 11D, 13D of the first and the second substrates 11, 13 by brazing, respectively. The module proper 100 is accommodated in the case 200 formed by the first and the second housings 7, 9 so that the first and the second electrodes 15A, 15B are electrically connected to a power unit 8 shown in Figs. 2 and 3.

Referring to Fig. 4, each thermoelectric conversion elements 17 is made of known p-type and n-type thermoelectric conversion elements made of a bismuth-tellurium series alloy. The thermoelectric conversion elements 17 are formed in the same prismatic shape. The thermoelectric conversion elements 17 are joined to the first electrodes 15A on the side of the first substrate 11 and to the second electrode 15B on the side of the second substrate 13 by soldering, respectively. The p-type and n-type thermoelectric conversion elements are disposed in a lattice arrangement between the first and the second substrates 11, 13 and electrically connected to each other in series through the first electrodes 15A on the side of the first substrate 11 and the second electrode 15B on the side of the second substrate 13. The thermoelectric conversion elements 17 are thermally connected in parallel to each other through the first and the second substrates 11, 13.

The thermoelectric conversion module 1 includes a plurality of substrate units each including the first substrate (11) and the second substrate (13) which is connected to the first substrate (11). Referring to Fig. 5, the first fin 19 includes a base 19A disposed parallel to the outer surface of the first substrate 11 and a plurality of plate portions 19B extending perpendicularly from the base 19A. The first fin 19 is of a corrugated fin type formed by bending an aluminum plate in a wave shape to form a plurality of the plate portions 19B. As shown in Fig. 4, the plate made of the plate portions 19B are disposed in such a way that a part of the plate extends through an area indicated by the reference A between two adjacent substrate units as viewed in a direction in which cooling refrigerant or long life coolant (hereinafter referred to merely as "LLC") flows in the thermoelectric conversion module, or a part of the plate is joined to the outer surface of the base 19A between two adjacent substrate units.

An aluminum plate is used for the base 19A as well as the plate portion 19B. The base 19A is formed in a rectangular shape so that a plurality of the first substrates 11 may be joined to the base 19A, as shown in Fig. 3. A recess 19D is formed in the base 19A at one end. The base 19A functions as a base plate of the present invention.

The plate portions 19B are directly joined to the outer surface 19C of the base 19A by brazing. The base 19A is joined to the first substrates 11 by soldering, or thermally joined to the outer surface of the first substrates 11. Specifically, the plate portions 19B are joined to the outer surface 19C of the base 19A, and then the base 19A is joined to the aluminum foil 11C of the first substrate 11 by soldering. Alternatively, the plate made of the plate portions 19B may be formed by a plurality of aluminum plates each extending perpendicularly from the outer surface of the base 19A. The plate portions 19B may be indirectly joined to the outer surface 19C of the base 19A, but is preferably directly joined to the outer surface 19C of the base 19A, thereby enhancing the effects of heat absorption and radiation or heat receiving. The plate portion 19B may be connected to the outer surface 19C of the base 19A by brazing or soldering.

Referring to Fig. 5, each second fin 21 is formed in a wave shape that includes a plurality of first plate portions 21A extending parallel to the outer surface of the second substrate 13 and a plurality of second plate portions 21B extending perpendicularly from the outer surface of the second substrate 13. The second fin 21 is of a corrugated fin type formed by bending an aluminum plate in a wave shape as in the case of the first fin 19. The second fin 21 is made small so as to suit to the shape of the second substrate 13 and shaped such that the dimension of the second fin 21 in a direction along the second substrate 13 is smaller than that of the first fin 19 in a direction along the first substrate 11. Unlike the first fin 19, the first plate portions 21A of the second fin 21 are directly joined to the aluminum foil 13C of the second substrate 13 by brazing. Alternatively, the first plate portion 21A of the second fin 21 may be joined to the aluminum foil 13C of the second substrate 13 by soldering. The first plate portion 21A of the second fin 21 and the aluminum foil 13C of the second substrate 13 which are brazed are joined together securely compared to a case that the first plate portion 21A of the second fin 21 and the aluminum foil 13C of the second substrate 13 are soldered. Since the second fin 21 and the second substrate 13 are joined together by brazing, durability of the thermoelectric conversion module 1 is enhanced. The second fin 21 made of the second plate portions 21B may be made of a plurality of aluminum plates extending perpendicularly from the outer surface 13B of the second substrate 13.

Referring to Fig. 3, the first housing 7 has a rectangular shape and cooperates with the base 19A to from therebetween a first space 7A. A partition wall 7B is formed in the first housing 7 so as to extend in the first space 7A perpendicularly from the bottom of the first housing 7. A first fluid passage 7C is formed in the first space 7A by the partition wall 7B that allows LLC serving as a first heat exchange medium to flow in one direction indicated by solid arrow in Fig. 3, or LLC flows through a first space 7A. LLC is formed by mixing many kinds of chemicals for preventing freezing and rusting and for obtaining a high boiling point property. A first inlet 7D and a first outlet 7E are formed in the first fluid passage 7C of the first housing 7 at the upstream and the downstream ends thereof, respectively.

A projection 7F is formed in the first housing 7 which is engageable with the recess 19D of the base 19A, and the first housing 7 is formed with a flat surface 7G on which the base 19A may be mounted. The power unit 8 is mounted to the first housing 7 and electrically connected to a control unit and a battery which are not shown in the drawing. The structure of the power unit 8 is generally known and, therefore, the description of the structure will be omitted.

The second housing 9 has a similar structure as the first housing 7. The second housing 9 is formed in a rectangular shape and cooperates with the outer surface of the second substrate 13 to form therebetween a second space 9A. A partition wall 9B is formed in the second housing 9 so as to extend in the second space 9A perpendicularly from the bottom surface of the second housing 9. A second fluid passage 9C is formed in the second space 9A by the partition wall 9B allows water serving as a second heat exchange medium to flow in one direction indicated by dotted arrow in Fig. 3. A second inlet 9D and a second outlet 9E are formed in the second fluid passage 9C of the second housing 9 at the upstream and the downstream ends thereof, respectively.

The module proper 100 and the first and the second housings 7, 9 are assembled together thereby to form the thermoelectric conversion module 1 shown in Fig. 2. More specifically, the base 19A of the first fin 19 is mounted to the flat surface 7G of the first housing 7 such that the recess 19D and the projection 7F are engaged with each other and, therefore, the module proper 100 is located within the first housing 7. Then, the first and the second housings 7, 9 are assembled together, as shown in Fig. 5. During the assembling, a gasket 23 is mounted between the first housing 7 and the base 19A, the second housing 9 and the second substrate 13, and the first and the second housings 7, 9, thus serving as a seal member fluid-tightly sealing the first space 7A and the second space 9A and a third space B in which the thermoelectric conversion elements 17 are disposed between the base 19A and the second substrate 13. Alternatively, an O-ring may be used as the seal member.

Thus, in the thermoelectric conversion module 1, the first fin 19 is located in the first fluid passage 7C, and the second fin 21 is located in the second fluid passage 9C.

As shown in Fig. 1, the radiator 3 is formed with an inlet 3Aand an outlet 3B and LLC introduced through the inlet 3A flows through the radiator 3 and flows out therefrom through the outlet 3B. Heat exchange is performed between LLC and the air outside the vehicle. An electric fan 3C is disposed adjacent to the radiator 3 and electrically connected to the control unit (not shown).

The vehicle is driven to move by the engine 4 serving as a drive source. The engine 4 has formed therein a water jacket (not shown). LLC flowing through the water jacket is capable of cooling and heating the engine 4. An inlet 4A and an outlet 4B are formed in the engine 4 so as to communicate with the water jacket. The structure of the engine 4 is generally known and, therefore, the description of the engine 4 will be omitted. Alternatively, an electric motor may be used as a drive source instead of the engine 4.

The vehicle interior heat exchanger 5 has formed therein an inlet 5A and an outlet 5B. The vehicle interior heat exchanger 5 is disposed in the vehicle interior. Water flows through the vehicle interior heat exchanger 5 and heat exchange is performed between the water in the vehicle interior heat exchanger 5 and the air in the vehicle interior. An electric fan 5C is disposed adjacent to the vehicle interior heat exchanger 5 and electrically connected to the control unit (not shown).

The outlet 3B of the radiator 3 and the inlet 4A of the engine 4 are connected to each other through a tube 25. The outlet 4B of the engine 4 and the first inlet 7D of the first housing 7 are connected to each other through a tube 26. The first outlet 7E of the first housing 7 and the inlet 3A of the radiator 3 are connected to each other through a tube 27. LLC flowing through the tubes 25 through 27 circulates through the thermoelectric conversion module 1, the radiator 3 and the engine 4 in this order. A first electric pump P1 is connected in the tube 27 and electrically connected to the control unit (not shown). The engine 4 is disposed between the tubes 25 and 26. A buttery may be added between the tubes 25 and 26. Alternatively, a battery may replace the engine 4. In addition, the first electric pump P1 may be disposed between the tubes 25 and 26.

The outlet 5B of the vehicle interior heat exchanger 5 and the second inlet 9D of the second housing 9 are connected to each other through the tube 28. The second outlet 9E of the second housing 9 and the inlet 5A of the vehicle interior heat exchanger 5 are connected to each other through the tube 29. Water flowing through the tubes 28, 29 and circulates through the thermoelectric conversion module 1 and the vehicle interior heat exchanger 5. A second electric pump P2 is connected in the tube 29 and electrically connected to the control unit (not shown). Alternatively, the second electric pump P2 may be connected in the tube 28.

The vehicle air conditioner performs cooling and heating operations by utilizing Peltier effect occurring in the thermoelectric conversion elements 17 of the thermoelectric conversion module 1 for air conditioning of the vehicle compartment.

The following will describe in detail the heating operation of the vehicle air conditioner having the thermoelectric conversion module according to the present embodiment. The control unit operates the electric fans 3C, 5C and the first and the second electric pumps P1, P2, so that LLC flows through the tubes 25 through 27 and also through the tubes 28, 29 in the directions indicated by the arrows in Fig. 2, respectively. The control unit causes electric current to be applied to the thermoelectric conversion module 1, or specifically to the module proper 100, in such a way that the module proper 100 on the side of the first substrate 11 functions as a heat absorber and the module proper 100 on the other side of the second substrate 13 functions as a heat radiator.

Thus, the module proper 100 on the side of the first substrate 11 absorbs heat from LLC flowing from the tube 26 into the first fluid passage 7C through the first inlet 7D, and the module proper 100 on the side of the second substrate 13 radiates heat to water flowing from the tube 28 into the second fluid passage 9C through the second inlet 9D.

In the vehicle air conditioner, wherein the engine 4 is disposed upstream of the thermoelectric conversion module 1 with respect to the LLC flowing direction, LLC flowing in the first fluid passage 7C may be heated sufficiently by the engine 4. Thus, the module proper 100 on the side of the first substrate 11 may absorb more heat, and on the side of the second substrate 13 radiate more heat.

The water heated by heat radiated from the module proper 100 on the side of the second substrate 13 and flowing out through the second outlet 9E flows through the tube 29 and the inlet 5A and reaches the vehicle interior heat exchanger 5. The vehicle interior heat exchanger 5 performs heat exchange between the heated water and the air in the vehicle compartment, thus heating the air in the vehicle compartment. The air thus heated is supplied positively to the vehicle compartment by the electric fan 5C.

LLC in the first fluid passage 7C, whose heat is absorbed by the module proper 100 on the side of the first substrate 11, flows through the first outlet 7E and the tube 27 and then into the radiator 3 through the inlet 3A. The radiator 3 performs heat exchange between the LLC and the air outside the vehicle. Thus, remaining heat of the LLC is discharged out of the vehicle by using the electric fan 3C, thus the LLC being further cooled.

The following will describe in detail the cooler operation of the vehicle air conditioner. The control unit causes the electric fans 3C, 5C and the first and the second electric pumps P1, P2 to be operated as in the heating operation. The control unit causes electric current to be applied to the module proper 100 in such a way that the side of the module proper 100 that is adjacent to the first substrate 11 and the other side thereof that is adjacent to the second substrate 13 function as a radiator and a heat absorber, respectively.

Thus, the module proper 100 on the side of the second substrate 13 absorbs heat from water flowing through the second fluid passage 9C and the module proper 100 on the side of the first substrate 11 radiates heat to LLC flowing through the first fluid passage 7C. The water cooled by absorption of heat by the module proper 100 on the second substrate 13 flows to the vehicle interior heat exchanger 5, where heat exchange is performed between the cooled water and air in the vehicle compartment and, therefore air in the vehicle compartment is cooled. The air thus cooled is supplied positively to the vehicle compartment by the electric fan 5C.

LLC in the first fluid passage 7C, which is heated by the radiated heat in the module proper 100 on the side of the first substrate 11, flows out through the first outlet 7E and into the radiator 3, where the LLC is cooled by heat exchange with air outside of the vehicle.

In the cooling operation, the control unit controls the operation of the first electric pump P1 so as to allow LLC to circulate through the radiator 3, the thermoelectric conversion module 1 and the engine 4 in this order. Since the radiator 3 is disposed upstream of the thermoelectric conversion module 1 with respect to the flowing direction of the LLC, the LLC cooled by the radiator 3 flows through the first fluid passage 7C of the thermoelectric conversion module 1. Thus, the module proper 100 on the side of the first substrate 11 may radiate more heat efficiently to LLC. The module proper 100 on the side of the second substrate 13 may absorb more heat from water flowing through the second fluid passage 9C and, therefore, air having lower temperature may be supplied to the vehicle compartment.

As shown in Fig. 4, the first and the second substrates 11, 13 are provided in plurality, respectively, in the module proper 100 of the thermoelectric conversion module 1, so that a large number of the thermoelectric conversion elements 17 may be provided in the entire module proper 100. In the module proper 100 wherein the second fins 21 are connected directly to the respective aluminum foils 13C forming the outer surfaces of the second substrate 13, the effects of heat absorption from and radiation to water in the second fluid passage 9C by the second fin 21 are enhanced. The second substrates 13 are made small and the second fin 21 is made small, accordingly, so that thermal deformation of the second substrate 13 caused by joining the second fin 21 to the second substrate 13 is reduced. Accordingly, stress in the thermoelectric conversion elements 17 in the module proper 100 may be reduced.

In the module proper 100 wherein the base 19A of the first fin 19 is used as the base plate of the present invention and in common for the plurality of the first and the second substrates 11, 13, the module proper 100 may be formed easily. Each first fin 19 is formed by directly joining the plate portions 19B to the base 19A. The plate made of the plate portions 19B is disposed in such a way that the plate extends through the position A between two adjacent substrate units each including the first and the second substrates 11, 13 in a direction in which the base 19A and the plate extend. The effects of heat absorption from and radiation to LLC in the first fluid passage 7C by the first fin 19 in the module proper 100 on the side of the first substrate 11 are enhanced.

In the module proper 100, the base 19A and the plate portions 19B are made of the same aluminum alloy having substantially the same coefficient of thermal expansion and joined together by brazing. The base 19A has a rigidity that is high relative to that of the plate portion 19B. Any thermal deformation of the first substrate 11 occurring by joining the base 19A to the plate portions 19B may be reduced. The same aluminum alloy means that the constituents of the aluminum alloy for the base 19A is require to completely match to the constituents of the aluminum alloy for the plate portions 19B. However, when the constituents of the aluminum alloy for the base 19A does not completely match to the constituents of the aluminum alloy for the plate portions 19B, it may be said that the base 19A and the plate portions 19B may be made of the same aluminum alloy if the base 19A and the plate portions 19B have the sufficient coefficient of thermal expansion and rigidity for obtaining the above advantageous effects. The base 19A and the plate portions 19B which are brazed are joined together securely and corrosion resistance of the joint by brazing is enhanced. Thus, the first fin 19 is hardly deteriorated by LLC flowing through the first fluid passage 7C. Therefore, many materials may be used as the first heat exchange medium.

In the module proper 100, the base 19A and the aluminum foils 11C of the outer surfaces of the first substrates 11 are joined together by soldering. The joining by soldering is conducted at a relatively low temperature in comparison with the joining by brazing, so that thermal deformation hardly occurs in the base 19A and the first substrate 11 when the first fin 19 and the first substrate 11 are joined together. Thus, any stress of the thermoelectric conversion elements 17 caused by joining the first fin 19 to the first substrate 11 may be reduced. Since the base 19A and the plate portions 19B are joined together by brazing, durability of the first fin 19 is enhanced.

As shown in Fig. 5, the thermoelectric conversion module 1 is constructed such that the module proper 100 is accommodated in the case 200 composed of the first and the second housings 7, 9. According to the thermoelectric conversion module 1, therefore, heat may be transferred between LLC flowing through the first fluid passage 7C and water flowing through the second fluid passage 9C.

According the to the thermoelectric conversion module 1, the first space 7A, the second space 9A and the third space B are fluid-tightly closed by the gasket 23, respectively, so that the LLC and the water hardly cause deterioration of the thermoelectric conversion elements 17 and electric leakage in the thermoelectric conversion module 1.

According to the module proper 100 of the thermoelectric conversion module 1, the base 19A is used in common for the plurality of the first and the second substrates 11, 13, so that a space for the gasket 23 is reduced. Therefore, the first and the second housings 7, 9, as well as the case 200, may be downsized.

The thermoelectric conversion module 1 has high performance and is easy to be mounted and, therefore, the vehicle air conditioner equipped with the thermoelectric conversion module 1 offers high performance and improved ease of mounting to the vehicle.

In the vehicle air conditioner, LLC is used as the first heat exchange medium, and the thermoelectric conversion module 1 may perform heat absorption from and radiation to the LLC. Using LLC that is normally used for cooling an engine makes it unnecessary to prepare any medium as the first heat exchange medium. Thus, the ease of mounting of the vehicle air conditioner and the thermoelectric conversion module 1 can be further improved, so that the manufacturing cost of the vehicle air conditioner and the vehicle equipped with such vehicle air conditioner may be reduced.

The partition walls 7B, 9B are formed in the first and the second housings 7, 9 to extend into the first and the second spaces 7A, 9A, respectively. The first fluid passage 7C is formed by the partition wall 7B in the first space 7A for allowing LLC to flow in one direction, and the second fluid passage 9C is formed by the partition wall 9B in the second spaces 9A for allowing water to flow in one direction.

Thus, the flow of LLC becomes complicated by the partition wall 7B in the first fluid passage 7C, and the flow of water also becomes complicated by the partition wall 9B in the second fluid passage 9C. In the thermoelectric conversion module 1, the module proper 100 is capable of transferring heat from LLC and water. Therefore, the thermoelectric conversion module 1 has a high conversion performance and the vehicle air conditioner with such the thermoelectric conversion module 1 offers a high air conditioning performance, accordingly.

The present invention is not limited to the above-described preferred embodiment, but it may be modified in various ways as exemplified below.

The module proper 100 may be constructed so that each plate portion 19B of the first fin 19 and each second plate portion 21B of the second fin 21 have different shapes.

The heat-transfer material for the first and the second fins have preferably higher heat conductivity than the material for the first and the second substrates and are preferably easily bent. A metal such as aluminum or copper fulfills the requirements. The first and the second fins may be made of the same or different heat transfer material or have the same or different shape.

Air may be used as the first and the second heat exchange medium instead of water and LLC. In this case, the first and the second heat exchange medium may be the same or different from each other.

The partition walls 7B, 9B may be formed in the first and the second housings 7, 9 by deforming parts of the first and the second housings 7, 9 or mounting another parts to the first and the second housings 7, 9, respectively. The partition walls 7B, 9B may be formed so as to extend in a direction parallel or perpendicular to the flowing direction of the first and the second heat exchange mediums. The partition walls 7B, 9B may be made of a plurality of partition walls oriented in different directions.

The present invention is applicable not only to a vehicle air conditioner or a household air conditioner operated by using Peltier effect of the thermoelectric conversion elements, but also to a vehicle power plant or a building power plant operated by using Seebeck effect of thermoelectric conversion elements.

A thermoelectric conversion module includes a plurality of first substrates and a plurality of second substrates disposed to face each other, a plurality of first electrodes and a plurality of second electrodes, a plurality of thermoelectric conversion elements, a base plate, first fins and second fins. Each inner surface of the first substrate faces the respective inner surface of the second substrate. The first electrode is joined to the respective inner surface of the first substrate and the second electrode the respective inner surface of the second substrate. The thermoelectric conversion elements are electrically connected to each other through the first and the second electrodes. The base plate is thermally joined to the outer surfaces of the first substrates. Each first fin is thermally joined to the outer surface of the base plate. Each second fin is thermally and directly joined to the respective outer surface of the second substrate.

## Claims

1. A thermoelectric conversion module (1) comprising:
a plurality of first substrates (11) and a plurality of second substrates (13) disposed to face each other, each first substrate (11) including an inner surface (11D) and an outer surface (11B), each second substrate (13) including an inner surface (13D) and an outer surface (13B), each inner surface (11D) of the first substrate (11) facing the respective inner surface (13D) of the second substrate (13);
a plurality of first electrodes (15A) each joined to the respective inner surface (11D) of the first substrate (11);
a plurality of second electrodes (15B) each joined to the respective inner surface (13D) of the second substrate (13);
a plurality of thermoelectric conversion elements (17) electrically connected to each other through the first electrodes (15A) and the second electrodes (15B);
a base plate (19A) made of a heat-transfer material, the base plate (19A) thermally joined to the outer surfaces (11B) of the first substrates (11), the base plate (19A) including an outer surface (19C);
first fins (19) made of a heat-transfer material, each first fin (19) thermally joined to the outer surface (19C) of the base plate (19); and
second fins (21) made of a heat-transfer material, each second fin (21) thermally and directly joined to the respective outer surface (13B) of the second substrate (13).

2. The thermoelectric conversion module (1) according to claim 1, **characterized in that** the first substrate (11) includes a ceramic plate (11A) and a metal foil (11C) which is integrally joined to at least one surface of the ceramic plate (11A), and the second substrate (13) includes a ceramic plate (13A) and a metal foil (13C) which is integrally joined to at least one surface of the ceramic plate (13A).

3. The thermoelectric conversion module (1) according to claim 1 or 2, **characterized in that** the first fin (19) is directly joined to the outer surface (19C) of the base plate (19A).

4. The thermoelectric conversion module (1) according to any one of claims 1 through 3, **characterized in that** the thermoelectric conversion module (1) further includes a case (200) including a first housing (7) disposed adjacent to the outer surface (19C) of the base plate (19) and a second housing (9) disposed adjacent to the outer surface (13B) of the second substrate (13), a first space (7A) is formed between the first housing (7) and the base plate (19A) such that a first heat exchange medium flows through the first space (7A), a second space (9A) is formed between the second housing (9) and the second substrate (13) such that a second heat exchange medium flows through the second space (9A), and the first space (7A), the second space (9A) and a space (B) in which the thermoelectric conversion elements (17) are disposed between the base plate (19A) and the second substrate (13) are fluid-tightly closed by a seal member (23), respectively.

5. The thermoelectric conversion module (1) according to claim 4, **characterized in that** long life coolant serves as the first heat exchange medium.

6. The thermoelectric conversion module (1) according to claim 4 or 5, **characterized in that** partition walls (7B, 9B) are formed in the first housing (7) and the second housing (9) to extend into the first space (7A) and the second space (9A), respectively.

7. The thermoelectric conversion module (1) according to any one of claims 1 through 6, **characterized in that** the first fin (19) includes a base disposed parallel to the outer surface (11B) of the first substrate (11) and a plate portion (19B) extending perpendicularly from the base, the base functions as the base plate (19A), and the plate portion (19B) is joined to the base by brazing.

8. The thermoelectric conversion module (1) according to claim 7, **characterized in that** the base plate (19A) and the plate portion (19B) are made of the same heat-transfer material.

9. The thermoelectric conversion module (1) according to any one of claims 1 through 8, **characterized in that** the base plate (19A) is joined to the first substrate (11) by soldering.

10. The thermoelectric conversion module (1) according to any one of claims 1 through 9, **characterized in that** the thermoelectric conversion module (1) includes a plurality of substrate units each including the first substrate (11) and the second substrate (13) which is connected to the first substrate (11), and the first fin (19) is disposed in such a way that a part of the first fin (19) is joined to the outer surface (19C) of the base plate (19A) between two adjacent substrate units.
